# DEMANDE DE BREVET EUROPEEN

(11) **EP 1 416 538 A2**
(43) Date de publication de la demande: **06.05.2004**
(21) Numéro de dépôt: 03300114.0
(22) Date de dépôt: 10.09.2003
(51) Int. Cl.: H01L 27/146, H01L 27/144

(54) **Photodétecteur d'un capteur d'images**

(30) Priorité: 11.09.2002 FR 0211215
(71) Demandeur: STMicroelectronics S.A., 92120 Montrouge (FR)
(72) Inventeur: Roy, M. Francois, 38180 Seyssins (FR)
(74) Mandataire: de Beaumont, Michel

(57) **Abrégé**

L'invention concerne un photodétecteur réalisé sous forme monolithique comportant une première zone active (10) de silicium monocristallin dopé correspondant à des première et seconde photodiodes (D2, D3) de même surface, à deux transistors MOS de transfert de charge (M4, M5) et à une diode de stockage (D1) ; une deuxième zone active (18) de silicium monocristallin dopé disposée à côté de la partie de la première zone active associée à la deuxième photodiode (D3) et correspondant à un interrupteur de précharge (M1) ; et une troisième zone active (20) de silicium monocristallin dopé disposée à côté de la partie de la première zone active associée à la première photodiode (D2) et correspondant à deux transistors MOS de lecture (M2, M3) en série, dans lequel les surfaces des deuxième et troisième zones actives exposées à un éclairement lumineux sont sensiblement identiques.

## Description

La présente invention concerne un photodétecteur, ou pixel, réalisé sous forme monolithique, d'un capteur d'images destiné à être utilisé dans des dispositifs de prise de vues tels que, par exemple, des caméras, des caméscopes, des microscopes numériques ou encore des appareils photographiques numériques.

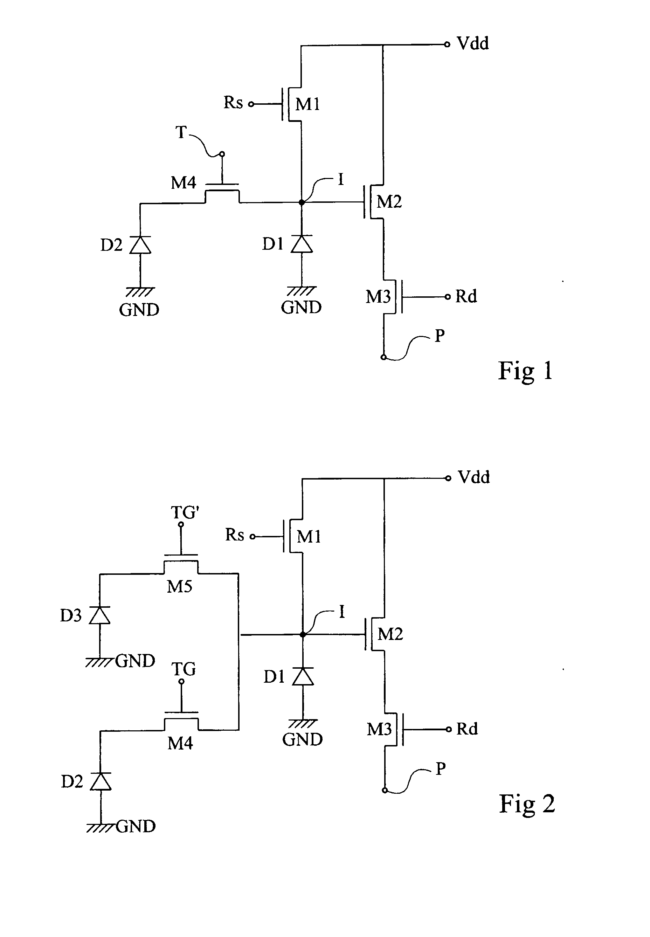

La figure 1 représente de façon schématique un pixel d'une matrice de pixels d'un capteur d'images. Chaque pixel comprend un dispositif de précharge et un dispositif de lecture. Le dispositif de précharge est constitué d'un transistor MOS à canal N M1, interposé entre un rail d'alimentation Vdd et un noeud de lecture I. La grille du transistor de précharge M1 reçoit un signal de commande de précharge Rs. Le dispositif de lecture est constitué de la connexion en série de deux transistors MOS à canal N. Le drain d'un premier de ces transistors de lecture, ci-après M2, est connecté au rail d'alimentation Vdd. La source du deuxième transistor de lecture M3 est connectée à la borne d'entrée P d'un circuit de traitement électronique. La grille du premier transistor de lecture M2 est reliée au noeud de lecture I. La grille du deuxième transistor de lecture M3 reçoit un signal de lecture Rd. La cathode d'une diode de stockage de charge D1 est reliée au noeud I. La cathode d'une photodiode D2 est reliée au noeud I par l'intermédiaire d'un transistor MOS à canal N de transfert de charge M4 dont la grille reçoit un signal de commande de transfert de charge T. Les anodes de la diode D1 et de la photodiode D2 sont reliées à un rail d'alimentation de référence ou masse du circuit GND.

Le fonctionnement de ce circuit est le suivant. Un cycle de photodétection commence par une phase de précharge pendant laquelle on impose à la diode D1 un niveau de tension de référence. Cette précharge s'effectue en rendant passant le transistor de précharge M1. Une fois la précharge effectuée, le transistor de précharge M1 est bloqué. Puis le système est maintenu tel quel, tous les transistors étant bloqués. On lit alors l'état au noeud I, c'est-à-dire l'état de charge de référence réel de la diode D1, en fermant pendant un très court instant le deuxième transistor de lecture M3.

Le cycle se poursuit par un transfert vers le noeud I des charges photogénérées, c'est-à-dire créées et stockées en présence d'un rayonnement, dans la photodiode D2. Ce transfert s'effectue en rendant passant le transistor de transfert M4. Le transfert fini, le transistor M4 est bloqué et la photodiode D2 recommence à photogénérer et stocker des charges qui seront ultérieurement transférées vers le noeud I. Après le transfert, on lit le nouvel état de charge de la diode D1. Le signal de sortie transmis à la borne P dépend alors du pincement du canal du premier transistor de lecture M2, qui est directement fonction de la charge stockée dans la photodiode. La lecture finie, le transistor M3 est bloqué et le cycle recommence par une précharge de la diode D1.

La figure 2 représente un schéma électrique d'une implantation pratique d'un pixel d'un capteur d'images.

En pratique, une autre photodiode D3 est montée en parallèle à la photodiode D2. L'anode de la photodiode D3 est reliée à la masse GND. La cathode de la photodiode D3 est reliée au noeud I par l'intermédiaire d'un transistor MOS M5 dont la grille est commandée par un signal de transfert T'.

Les étapes du procédé de lecture précédemment décrit sont alors réalisées alternativement pour les photodiodes D2 et D3.

Un tel schéma électrique consiste donc à mettre en commun, pour deux photodiodes D2, D3 de deux pixels, les transistors de lecture M2, M3 et le transistor de précharge M1. Une telle structure est appelée pixel 2,5T puisqu'elle comporte 5 transistors MOS pour deux photodiodes D2, D3, c'est-à-dire "2,5 transistors" par photodiode.

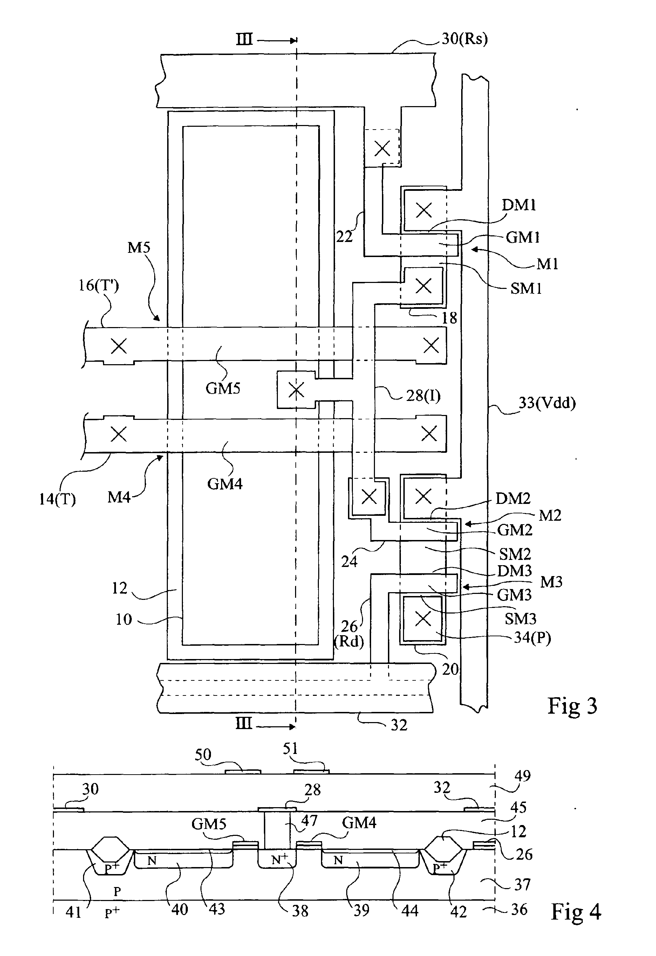

La figure 3 représente, de façon schématique, un exemple classique de topologie d'un pixel 2,5T dans laquelle le circuit électrique de la figure 2 est réalisé par une technologie à un niveau de silicium polycristallin et trois niveaux de métallisation. D'autres niveaux de silicium polycristallin et de métallisation peuvent être présents et utilisés.

Les surfaces délimitées par un trait fin correspondent à des zones actives de substrat semiconducteur, à des bandes de silicium monocristallin déposées sur le substrat et correspondant aux grilles de transistors MOS, ou à des bandes métalliques de niveau 1 ou 2. Les traits pointillés indiquent des portions de bandes de silicium polycristallin disposées sous des portions de bandes métalliques ou des portions de zones actives disposées sous des bandes de silicium polycristallin ou des bandes métalliques. Bien que la vue ne soit pas représentée à l'échelle, les dimensions relatives de chaque région sont conservées de façon à représenter l'encombrement réel du circuit intégré. Les croix représentent des contacts reliant, à travers les couches isolantes situées entre les niveaux de métallisation, des bandes métalliques à des zones actives ou à des bandes de silicium polycristallin ou des vias reliant, à travers des couches isolantes situées entre les niveaux de métallisation, des bandes métalliques à d'autres bandes métalliques.

Une zone active 10 correspond aux photodiodes D2, D3, aux transistors de transfert M4, M5 et à la diode de stockage D1. La zone active 10 peut être réalisée selon une technologie LOCOS. La référence 12 représente une zone d'isolement de champ par exemple en oxyde de silicium qui délimite la zone active 10.

La grille GM4 du transistor MOS M4 correspond à une portion d'une bande de silicium polycristallin 14. La grille GM5 du transistor MOS M5 correspond à une portion d'une bande de silicium polycristallin 16. La photodiode D2 est réalisée dans la partie de la zone active 10 au-dessous de la grille GM4. La photodiode D3 est réalisée dans la partie de la zone active 10 au-dessus de la grille GM5. La diode de stockage D1 est réalisée entre les bandes de silicium polycristallin 14, 16. Une zone active 18 correspond au transistor MOS de précharge M1. Une zone active 20 correspond aux premier et deuxième transistors MOS de lecture M2, M3. La grille GM1 du transistor MOS M1 correspond à une portion d'une bande de silicium polycristallin 22. La grille GM2 du transistor MOS M2 correspond à une portion d'une bande de silicium polycristallin 24. La grille GM3 du transistor MOS de lecture M3 correspond à une portion d'une bande de silicium polycristallin 26 qui conduit le signal de lecture Rd. Une bande métallique 28 de niveau 1 est reliée à la source SM1 du transistor MOS M1, à la bande de silicium polycristallin 24 et à la zone active 10 entre les bandes de silicium polycristallin 14, 16. Une bande métallique 30 de niveau 1 est reliée à la bande de silicium polycristallin 22 et conduit le signal de commande de précharge Rs. Une bande métallique 32 de niveau 1, recouvrant en partie la bande de silicium polycristallin 26, joue un rôle analogue au rôle de la bande métallique 30 pour la rangée adjacente à la rangée associée au pixel 2,5T représentée en figure 3 et située au-dessous de celle-ci. Les drains DM1, DM2 des transistors MOS M1, M2 sont reliés à une bande métallique 33 de niveau 3 à la tension d'alimentation Vdd. La source SM3 du transistor MOS M3 est connectée à une bande métallique de niveau 2 reliée au système de traitement électronique (non représenté), seule une portion métallique 34 de niveau 1 étant représentée. Des bandes métalliques de niveau 1 et 2 (non représentées en figure 3) sensiblement superposées aux bandes de silicium polycristallin 14, 16 transportent les signaux de transfert de charge T, T' et sont régulièrement connectées aux-dites bandes de silicium polycristallin 14, 16 de façon à compenser la résistance du silicium polycristallin et assurer que tous les pixels d'une ligne reçoivent les signaux T, T' au même instant.

La figure 4 représente une section partielle et schématique du pixel de la figure 3 selon la ligne III-III. Le pixel est réalisé dans un substrat 36 d'un premier type de conductivité, par exemple de type P, fortement dopé (P+). La zone active 10 correspond à un caisson 37 du même type de conductivité que le substrat 36, mais plus faiblement dopé. Une région de drain 38 du type de conductivité opposé, par exemple N, fortement dopée (N+) s'étend entre les deux grilles GM4, GM5 des transistors MOS M4, M5. Sur la droite de la grille GM4 du transistor MOS M4 et sur la gauche de la grille GM5 du transistor MOS M5 se trouvent des régions de source 39, 40 du type de conductivité opposé. Les régions de source 39, 40 sont réalisées sur une surface beaucoup plus importante que la région de drain 38 et forment avec le caisson 37 sous-jacent les jonctions des photodiodes D2, D3. Des régions de type P 41, 42 fortement dopées (P+) sont connectées au potentiel de référence ou à la masse par l'intermédiaire du caisson 37 et du substrat 36. Chaque photodiode D2, D3 est du type dit complètement déplété et comporte, à la surface de la région de source 39, 40, une région de type P 43, 44, peu profonde et très fortement dopée. Ces régions 43, 44 sont en contact avec les régions 41, 42 et sont donc maintenues en permanence au niveau de la tension de référence.

Une première couche isolante 45 recouvre la structure précédemment décrite. La bande métallique 28 de niveau 1 est reliée à la région de drain 38 par un contact 47. Une deuxième couche isolante 49 recouvre la première couche isolante 45 et les bandes métalliques 28, 30, 32 du premier niveau de métallisation. Deux bandes métalliques 50, 51 de niveau 2 s'étendent sensiblement parallèlement aux bandes de silicium polycristallin 14, 16 .

Les couches isolantes 45, 49 sont constituées d'un matériau isolant transparent de sorte que les rayons lumineux puissent atteindre les photodiodes D2, D3. L'absorption de photons entraîne au niveau des photodiodes D2, D3 la libération d'électrons qui sont stockés dans les régions 39, 40 de type N. L'absorption de photons au niveau des parties exposées à la lumière des zones actives 18, 20 et des bandes de silicium polycristallin 22, 24, 26 peut également provoquer dans ces éléments la libération d'électrons qui tendent à diffuser vers la région 39, 40 de la photodiode D2, D3 la plus proche et à participer à la charge de la photodiode D2, D3. En particulier, les électrons issus de la zone active 20 et des bandes de silicium polycristallin 24, 26 tendent à diffuser principalement vers la photodiode D2, tandis que les électrons issus de la zone active 18 et de la bande de silicium polycristallin 22 tendent à diffuser principalement vers la photodiode D3. Etant donné que les surfaces exposées des zones actives 18, 20 sont différentes, et que les surfaces exposées des bandes de silicium polycristallin 22, 24, 26 sont également différentes, on obtient une diffusion inégale d'électrons vers les photodiodes D2, D3 pour une même exposition lumineuse. Cela conduit à une charge différente stockée dans les photodiodes D2, D3 pour une même exposition lumineuse. Des tensions différentes sont alors obtenues lors du transfert des charges des photodiodes D2, D3.

Au niveau du système de traitement électronique, une telle différence se traduit par un bruit fixe. Ce défaut très gênant peut être en partie corrigé en utilisant des gains d'amplification différents pour le traitement électronique des signaux issus des photodiodes D2 ou D3. Toutefois, une telle correction sélective est difficilement réalisable sur l'ensemble des amplitudes des signaux pouvant être obtenus.

Une autre possibilité consiste à masquer les zones actives 18, 20 et les bandes de silicium polycristallin 22, 24, 26 ne devant pas être exposées à la lumière par une couche métallique d'un niveau de métallisation supérieur au niveau 2. Toutefois, ceci implique la réalisation d'un niveau de métallisation supplémentaire et entraîne des couplages capacitifs parasites entre le métal ajouté et les bandes métalliques d'autres niveaux de métallisation. En outre, l'efficacité du masquage obtenu peut être imparfaite étant donné l' éloignement du masque métallique et des photodiodes.

La présente invention vise à obtenir un pixel du type 2,5T ne présentant pas l'inconvénient précédemment mentionné.

Dans ce but, elle prévoit un photodétecteur réalisé sous forme monolithique comportant une première zone active de silicium monocristallin dopé correspondant à des première et seconde photodiodes de même surface, à deux transistors MOS de transfert de charge et à une diode de stockage, la cathode de chaque photodiode étant reliée à la cathode de la diode de stockage par l'intermédiaire de l'un des transistors MOS de transfert de charge ; une deuxième zone active de silicium monocristallin dopé disposée à côté de la partie de la première zone active associée à la deuxième photodiode et correspondant à un interrupteur de précharge dont une première borne est reliée à la cathode de la diode de stockage et dont une seconde borne est reliée à un potentiel de référence ; et une troisième zone active de silicium monocristallin dopé disposée à côté de la partie de la première zone active associée à la première photodiode et correspondant à deux transistors MOS de lecture en série, la grille de l'un des transistors de lecture étant reliée à la cathode de la diode de stockage et le drain ou la source de l'un des transistors de lecture étant relié à un système de traitement, dans lequel les surfaces des deuxième et troisième zones actives exposées à un éclairement lumineux sont sensiblement identiques.

Selon un mode de réalisation de l'invention, les deuxième et troisième zones actives ont des surfaces sensiblement identiques.

Selon un mode de réalisation de l'invention, les première, deuxième et troisième zones actives sont rectangulaires, les deuxième et troisième zones actives étant de mêmes dimensions et sensiblement alignées à une même distance d'un côté de la première zone active.

Selon un mode de réalisation de l'invention, l'interrupteur de précharge est un transistor MOS à deux grilles parallèles.

Selon un mode de réalisation de l'invention, les grilles des deux transistors de lecture correspondent à des parties de première et deuxième bandes de silicium polycristallin et les deux grilles du transistor MOS à deux grilles correspondent à des parties de troisième et quatrième bandes parallèles de silicium polycristallin, la somme des surfaces exposées à la lumière des troisième et quatrième bandes parallèles de silicium polycristallin étant sensiblement égale à la somme des surfaces exposées à la lumière des première et deuxième bandes de silicium polycristallin.

Selon un mode de réalisation de l'invention, une cinquième bande de silicium polycristallin, perpendiculaire aux troisième et quatrième bandes parallèles de silicium polycristallin, relie les troisième et quatrième bandes parallèles.

Selon un mode de réalisation de l'invention, le photodétecteur comprend une bande métallique connectée à la cinquième bande de silicium polycristallin, ladite bande métallique comprenant une extension recouvrant partiellement la deuxième bande de silicium polycristallin.

Selon un mode de réalisation de l'invention, les grilles des transistors MOS de transfert de charge correspondent à des parties de bandes de silicium polycristallin qui s'étendent entre les deuxième et troisième zones actives.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente un schéma électrique d'un photodétecteur à une photodiode d'un capteur d'images classique ;
la figure 2, précédemment décrite, représente un schéma électrique d'un photodétecteur à deux photodiodes d'un capteur d'images classique ;
la figure 3, précédemment décrite, représente un exemple de topologie du photodétecteur de la figure 2 ;
la figure 4, précédemment décrite, représente une section schématique du photodétecteur de la figure 3 selon la ligne III-III ; et

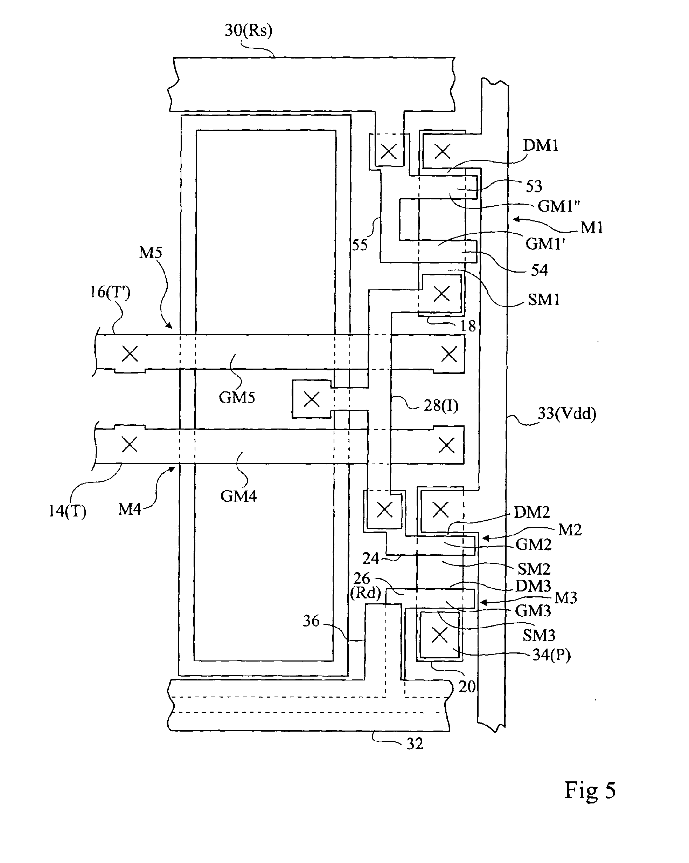

la figure 5 représente un mode de réalisation d'une topologie d'un photodétecteur à deux photodiodes selon l'invention.

Dans la suite de la description, des mêmes références désignent des mêmes éléments.

Le principe de l'invention consiste à fixer les dimensions des zones actives 18, 20 des transistors de recharge et de lecture M1, M2, M3 et les dimensions des bandes de silicium polycristallin 24, 26 associées de façon que la surface exposée de la zone active 18 correspondant au transistor de recharge M1 soit sensiblement égale à la surface exposée de la zone active 20 correspondant aux transistors de lecture M2, M3 et que les surfaces exposées des portions de silicium polycristallin associées au transistor de recharge M1 soient sensiblement égales à la somme des surfaces exposées des bandes de silicium polycristallin 24, 26 associées aux transistors de lecture M2, M3. On obtient ainsi des phénomènes d'absorption de photons et de diffusion d'électrons sensiblement identiques au-dessus de la bande silicium polycristallin 16 et au-dessous de la bande de silicium polycristallin 14.

La présente invention prévoit d'utiliser comme transistor de précharge un transistor MOS M1 comportant deux grilles GM1', GM1" parallèles, et appelé transistor à double grille. Les grilles GM1', GM1" du transistor MOS M1 à double grille correspondent à des portions parallèles 53, 54 de bandes de silicium polycristallin reliées à une portion principale 55 de silicium polycristallin connectée à la bande métallique 30. Ceci permet de réaliser une zone active 18 du transistor MOS M1 dont les dimensions sont sensiblement égales aux dimensions de la zone active 20 et de prévoir des surfaces exposées des portions de silicium polycristallin 53, 54, 55 sensiblement égales à la somme des surfaces exposées des bandes de silicium polycristallin 24, 26.

En outre, la bande métallique 32 peut comprendre une extension 36 qui recouvre partiellement la bande de silicium polycristallin 26 associée au transistor MOS M3 pour favoriser la symétrie du pixel.

Dans le présent mode de réalisation, les grilles GM1', GM1" du transistor MOS M1 sont toutes deux connectées à la bande métallique 30 et reçoivent donc le même signal de commande de précharge Rs. Il est toutefois possible de connecter les grilles GM1', GM1" à deux bandes métalliques différentes de façon à commander chaque grille GM1', GM1" par un signal de commande de précharge spécifique.

De même, dans le présent mode de réalisation, les drains DM1, DM2 des transistors MOS M1, M2 sont connectés à la bande métallique 33 de niveau 3 à la tension d'alimentation Vdd. Il est toutefois possible de connecter les drains DM1, DM2 à des bandes métalliques distinctes à des tensions différentes.

Le pixel selon l'invention étant sensiblement symétrique, les tensions au noeud de lecture I issues de l'étape de décharge des photodiodes D2, D3 sont sensiblement identiques pour une même exposition lumineuse. On supprime donc tout bruit indésirable. Un même gain d'amplification peut alors être utilisé par le système de traitement électronique pour les signaux issus des deux photodiodes.

Bien entendu, la présente invention est susceptible de diverses variantes et modifications qui apparaîtront à l'homme de l'art. Ainsi, certains des transistors MOS à canal N peuvent être remplacés par des transistors à canal P. En outre, la réalisation de la cellule a été décrite comme mettant en oeuvre un niveau de silicium polycristallin et trois niveaux de métallisation. Il est tout à fait possible de remplacer les bandes métalliques d'un ou plusieurs niveaux de métallisation par un autre matériau conducteur. Par exemple, le premier niveau de métallisation peut être remplacé par un niveau deux de silicium polycristallin dopé.

## Revendications

1. Photodétecteur réalisé sous forme monolithique comportant :
une première zone active (10) de silicium monocristallin dopé correspondant à des première et seconde photodiodes (D2, D3) de même surface, à deux transistors MOS de transfert de charge (M4, M5) et à une diode de stockage (D1), la cathode de chaque photodiode étant reliée à la cathode de la diode de stockage par l'intermédiaire de l'un des transistors MOS de transfert de charge ;
une deuxième zone active (18) de silicium monocristallin dopé disposée à côté de la partie de la première zone active associée à la deuxième photodiode (D3) et correspondant à un interrupteur de précharge (M1) dont une première borne est reliée à la cathode de la diode de stockage et dont une seconde borne est reliée à un potentiel de référence (Vdd) ; et
une troisième zone active (20) de silicium monocristallin dopé disposée à côté de la partie de la première zone active associée à la première photodiode (D2) et correspondant à deux transistors MOS de lecture (M2, M3) en série, la grille (GM2) de l'un des transistors de lecture étant reliée à la cathode de la diode de stockage et le drain ou la source (SM3) de l'un des transistors de lecture étant relié à un système de traitement,
**caractérisé en ce que** les surfaces des deuxième et troisième zones actives exposées à un éclairement lumineux sont sensiblement identiques.

2. Photodétecteur selon la revendication 1, dans lequel les deuxième et troisième zones actives (18, 20) ont des surfaces sensiblement identiques.

3. Photodétecteur selon la revendication 2, dans lequel les première, deuxième et troisième zones actives (10, 18, 20) sont rectangulaires, les deuxième et troisième zones actives (18, 20) étant de même dimensions et sensiblement alignées à une même distance d'un côté de la première zone active (10).

4. Photodétecteur selon la revendication 1, dans lequel l'interrupteur de précharge (M1) est un transistor MOS à deux grilles (GM1', GM1") parallèles.

5. Photodétecteur selon la revendication 4, dans lequel les grilles (GM2, GM3) des deux transistors de lecture (M2, M3) correspondent à des parties de première et deuxième bandes de silicium polycristallin (24, 26) et dans lequel les deux grilles (GM1', GM1") du transistor MOS (M1) à deux grilles correspondent à des parties de troisième et quatrième bandes parallèles de silicium polycristallin (53, 54), la somme des surfaces exposées à la lumière des troisième et quatrième bandes parallèles de silicium polycristallin étant sensiblement égale à la somme des surfaces exposées à la lumière des première et deuxième bandes de silicium polycristallin.

6. Photodétecteur selon la revendication 5, dans lequel une cinquième bande de silicium polycristallin (55), perpendiculaire aux troisième et quatrième bandes parallèles de silicium polycristallin (53, 54), relient les troisième et quatrième bandes parallèles.

7. Photodétecteur selon la revendication 6, comprenant une bande métallique (30, 32) connectée à la cinquième bande de silicium polycristallin (55), ladite bande métallique comprenant une extension (36) recouvrant partiellement la deuxième bande de silicium polycristallin (26).

8. Photodétecteur selon la revendication 1, dans lequel les grilles (GM4, GM5) des transistors MOS (M4, M5) de transfert de charge correspondent à des parties de bandes de silicium polycristallin (14, 16) qui s'étendent entre les deuxième et troisième zones actives (18, 20).
